(19) Europäisches Patentamt
European Patent Office
Office européen des brevets

(11) Veröffentlichungsnummer: **0 146 501**
**B1**

(12) # EUROPÄISCHE PATENTSCHRIFT

(45) Veröffentlichungstag der Patentschrift: **16.03.88**

(51) Int. Cl.⁴: **C 08 G 85/00,** G 03 C 1/68, C 08 J 3/24

(21) Anmeldenummer: **84810574.8**

(22) Anmeldetag: **26.11.84**

(54) **Polymerisierbare Zusammensetzungen.**

(30) Priorität: **01.12.83 GB 8332073**

(43) Veröffentlichungstag der Anmeldung: **26.06.85 Patentblatt 85/26**

(45) Bekanntmachung des Hinweises auf die Patenterteilung: **16.03.88 Patentblatt 88/11**

(84) Benannte Vertragsstaaten: **BE CH DE FR GB IT LI NL SE**

(56) Entgegenhaltungen:
**EP-A-0 010 897**
**EP-A-0 104 143**
**EP-A-0 104 144**
**EP-A-0 118 044**
**FR-A-2 322 897**

(73) Patentinhaber: **CIBA- GEIGY AG, Klybeckstrasse 141, CH- 4002 Basel (CH)**

(72) Erfinder: **Irving, Edward, Dr., 41, Swaffham Road, Burwell, Cambridge CB5 OAN (GB)**

**EP 0 146 501 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1988

**Beschreibung**

Die vorliegende Erfindung betrifft Zusammensetzungen mit einem Gehalt an kationisch polymerisierbarem Material, einer Hydroxyverbindung und einem aromatischen Jodosylsalz. Sie erstreckt sich auch auf die Polymerisation derartiger Zusammensetzungen mittels aktinischer Strahlung oder Wärme. Diese Zusammensetzungen können als Oberflächenbeschichtungen, bei der Herstellung von Druckplatten und gedruckten Schaltungen, sowie als Klebstoffe, verwendet werden.

Bekanntlich ist es wünschenswert, die Polymerisation in organischen Materialien mittels aktinischer Strahlung einzuleiten. Mit solchen Verfahren lässt sich beispielsweise die Verwendung toxischer und/oder brennbarer Lösungsmittel mit ihren Folgeproblemen der Umweltbelastung und Kosten für ihre Rückgewinnung vermeiden. Die Photopolymerisation ermöglicht es, das Unlöslichmachen von Harzzusammensetzungen auf bestimmte Zonen zu beschränken, d.h. auf die bestrahlten Stellen, und erlaubt so die Herstellung gedruckter Schaltungen und Druckplatten bzw. ermöglicht es, die Haftung an Substraten auf eng umrissene Zonen zu begrenzen. Ferner sind Bestrahlungsverfahren häufig schneller als solche, bei denen Erhitzen und folglich eine Abkühlungsstufe erforderlich sind.

Photopolymerisierbare Zusammensetzungen mit einem Gehalt an kationisch polymerisierbarem Material, einer Hydroxyverbindung und einem aromatischen Jodoniumsalz als Photopolymerisationskatalysator sind schon bekannt. Die Anwesenheit der Hydroxyverbindung verbessert die Flexibilität der photopolymerisierten Zusammensetzung.

So beschreibt die US-A-4 256 828 (=FR-A-2 322 897) photopolymerisierbare Zusammensetzungen mit einem Gehalt an Polyepoxid, einem organischen Material mit einer Hydroxyfunktionalität von wenigstens 1 und einem aromatischen Jodoniumsalz der Formel

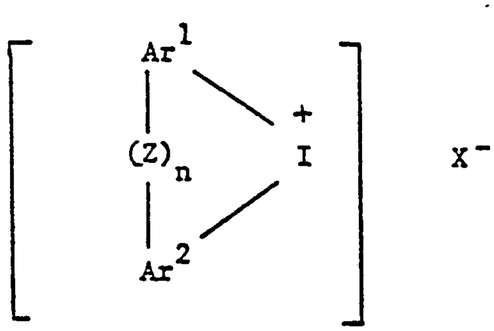 I

als Photoinitiator, worin $Ar^1$ und $Ar^2$ aromatische Gruppen mit 4 bis 20 Kohlenstoffatomen in Form von Phenyl-, Thienyl-, Furanyl- oder Pyrazolylgruppen, Z ein Sauerstoff- oder Schwefelatom oder eine Gruppe der Formel

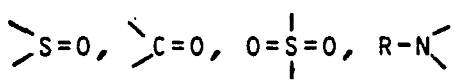

(worin R eine Arylgruppe mit 6 bis 20 Kohlenstoffatomen oder eine Acylgruppe mit 2 bis 20 Kohlenstoffatomen bedeutet), eine Kohlenstoff-Kohlenstoffbindung oder eine Gruppe der Formel

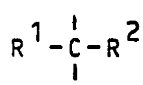

(worin $R^1$ und $R^2$ jeweils für ein Wasserstoffatom, eine Alkylgruppe mit 1 bis 4 Kohlenstoffatomen oder eine Alkenylgruppe mit 2 bis 4 Kohlenstoffatomen stehen), darstellen, n 0 oder 1 ist und $X^-$ ein Tetrafluoroborat-, Hexafluorophosphat-, Hexafluoroarsenat- oder Hexafluoroantimonatanion bedeutet.

Aus der US-A-4 090 936 sind lichthärtbare flüssige Zusammensetzungen mit einem Gehalt an organischem Material mit einer durchschnittlichen Epoxidfunktionalität von 1 bis 1,3, einem verträglichen organischen Polymer mit einem Glasumwandlungspunkt im Bereich von -20°C bis 105°C, wobei das organische Polymer ein Acrylat- oder Methacrylatpolymer darstellt, einem Copolymer aus Styrol und Allylalkohol oder einem Polyvinylbutyral und einem aromatischen Komplexsalz als Photoinitiator, beispielsweise einem aromatischen Jodoniumsalz der Formel I, bekannt.

Der Gebrauch von aromatischen Jodoniumsalzen als hitzeaktivierbare Härter für kationisch polymerisierbare Materialien in Gegenwart von bestimmten Katalysatoren ist beispielsweise aus US-A-4 192 924 bekannt, wonach der Katalysator ein Gemisch aus einem Kupfersalz und Ascorbinsäure, einem Ascorbat, Zinnsalz oder einer aktivierten α-Hydroxyverbindung ist, ebenso aus US-A-4 374 751, wonach der Katalysator ein Peroxyd ist.

In einem Artikel von F.M. Beringer und P. Bodlaender, J. Org. Chem., 1968, 33, 2981-4 sind eine Reihe von Diaryljodosylsalzen und ihre Herstellung beschrieben. Dieser Artikel vermittelt jedoch keinen Hinweis darüber, wie sich solche Salze unter aktinischer Bestrahlung oder bei Erhitzung in Anwesenheit anderer organischer Materialien verhalten, oder wie sie sich verwenden lassen.

Überraschenderweise wurde nun gefunden, dass aromatische Jodosylsalze als Photoinitiatoren für die Polymerisation von Zusammensetzungen mit einem Gehalt an Epoxiden oder anderen kationisch polymerisierbaren Materialien und Hydroxyverbindungen wirken, und dass die Salze als hitzeaktivierbare Polymerisationsmittel für derartige Zusammensetzungen in Anwesenheit gewisser Katalysatoren fungieren. Keine der obenstehend genannten Veröffentlichungen des Standes der Technik legte es nahe, dass ein Jodosylsalz solche wertvollen Eigenschaften besitzen würde.

Die aromatischen Jodosylsalze der erfindungsgemässen Zusammensetzungen sind im allgemeinen viel leichter zugänglich als die aromatischen Jodoniumsalze der vorbekannten Zusammensetzungen, wobei die Herstellung der Jodoniumsalze im allgemeinen komplizierte präparative Schritte unter Einhaltung strenger Bedingungen verlangt. Im Falle von Zusammensetzungen mit einem Gehalt an bestimmten Typen von kationisch polymerisierbarem Material, insbesondere cycloaliphatischen Epoxidharzen, sind die erfindungsgemässen Zusammensetzungen schneller photopolymerisierbar als die entsprechenden Zusammensetzungen mit einem Gehalt an Jodoniumsalzen und ergeben polymerisierte Produkte vergleichbarer Flexibilität. Was Zusammensetzungen anbelangt, welche unter Verwendung von Jodoniumsalzen kationisch polymerisiert wurden, sind solche mit einem Gehalt an cycloaliphatischen Epoxidharzen gewöhnlich reaktionsfähiger als Epoxidharze auf Bisphenolbasis. Dieser Unterschied in der Reaktionsfähigkeit ist noch ausgeprägter bei den unter Verwendung von aromatischen Jodosylsalzen polymerisierten Zusammensetzungen.

Gegenstand vorliegender Erfindung sind dementsprechend polymerisierbare Zusammensetzungen mit einem Gehalt an (A) kationisch polymerisierbarem Material,

(B) einer epoxidfreien organischen Hydroxyverbindung mit mindestens einer alkoholischen-Hydroxygruppe, ausschliesslich solcher Hydroxyverbindungen, welche beim Erhitzen auf eine Temperatur Über 50°C freie Radikale bilden, und

(C) einem aromatischen Jodosylsalz der Formel

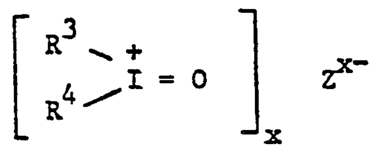

II

worin $R^3$ und $R^4$ gleich oder verschieden sein können und jeweils einen einwertigen aromatischen Rest mit 4 bis 25 Kohlenstoffatomen bedeuten, x 1, 2 oder 3 ist, und $Z^{x-}$ ein x-wertiges Anion einer Protonensäure bedeutet.

Ein weiterer Gegenstand der Erfindung ist ein Verfahren zur Herstellung eines polymeren Materials, welches folgende Schritte umfasst:

(i) Bestrahlen einer (A) ein kationisch polymerisierbares Material, (B) eine epoxidfreie organische Hydroxyverbindung mit mindestens einer alkoholischen Hydroxygruppe, ausschliesslich solcher Hydroxyverbindungen, welche beim Erhitzen auf eine Temperatur über 50°C freie Radikale bilden und (C) ein Jodosylsalz der Formel II enthaltenden Zusammensetzung mit Strahlung einer das Jodosylsalz aktivierenden Wellenlänge, vorzugsweise im Bereich von 200 bis 600 nm, und/oder (ii) Erhitzen auf über 50°C der erfindungsmässen Zusammensetzung oder der Zusammensetzung erhalten durch Bestrahlen der erfindungsgemässen Zusammensetzung in Anwesenheit von (D) eines Salzes oder Komplexes eines Übergangsmetalls (3), eines Zinn-II-salzes, eines organischen Peroxyds oder einer aktivierten, beim Erhitzen auf eine Temperatur über 50°C freie Radikale bildenden α-Hydroxyverbindung, als Katalysator für das Jodosylsalz, bis die Zusammensetzung polymerisiert ist. Das kationisch polymerisierbare Material (A) kann beispielsweise ein cyclischer Ether wie ein Oxetan oder Tetrahydrofuran, ein cyclischer Ester wie ein Lacton oder Episulfid wie Ethylensulfid, ein Vinylmonomer wie ein Vinylether, Styrol, Vinylcarbazol oder ein Vinylpräpolymer sein. Bei (A) handelt es sich vorzugsweise um ein 1,2-Epoxid wie Ethylenoxyd, Propylenoxyd oder ein Epoxidharz, ein Phenoplast, Aminoplast, wie ein Harnstoff/Formaldehyd- oder Melamin/Formaldehydharz oder einen cyclischen Vinylether. Besonders bevorzugte kationisch polymerisierbare Materialien sind cycloaliphatische Epoxidharze wie 3,4-Epoxycyclohexan-carbonsäure-3',4'-epoxycyclohexylmethylester und dessen 6,6'-Dimethylderivat, Ethylenglykolbis -(3,4-epoxycyclohexancarboxylat), Bis-(3,4-epoxycyclohexylmethyl)adipat, Dicyclopentadiendioxid und Vinylcyclohexendioxid, gegebenenfalls vorverlängerte Polyglycidylether von mehrwertigen Alkoholen wie 1,4-Butandiol und Diethylenglykol und mehrwertigen Phenolen wie 2,2-Bis-(4-hydroxyphenyl)propan und Phenol/Aldehydnovolaken, cyclische Vinylether mit einem Dihydropyranrest wie 3,4-Dihydro-2H-pyran-2-carbonsäure-3,4-dihydro-2H-pyran-2-ylmethylester und Phenol/Formaldehydresole. Mischungen aus zwei oder mehr kationisch polymerisierbaren Materialien können ebenfalls Verwendung finden.

Die Hydroxyverbindung (B) ist im allgemeinen ein epoxidfreies organisches Material mit einer oder mehreren primären oder sekundären alkoholischen Hydroxygruppen, welches nicht durch andere Gruppen so aktiviert wird, dass es beim Erhitzen auf über 50°C freie Radikale bildet. Es sind auch Mischungen von Hydroxyverbindungen verwendbar. Monohydroxyverbindungen, insbesondere solche mit einem Molekulargewicht von 60 bis 250 sind bei bestimmten Anwendungen brauchbar, zum Beispiel bei der Formulierung niedrigviskoser Beschichtungszusammensetzungen. Beispiele für geeignete Monohydroxyverbindungen sind Alkanole wie 1-Butanol, 1-Octanol, 1-Decanol, Cyclohexanol und

Cyclohexylmethanol, Aralkylalkohole wie Benzylalkohol, Monoalkylether von Alkylenglykolen wie 2-Methoxyethanol, 2-Ethoxyethanol und 2-Butoxyethanol sowie Monoalkylether von Polyoxyalkylenglykolen wie Methyland Ethylether von Polyoxyethylen- und Polyoxypropylenglykolen.

Im allgemeinen sind Hydroxyverbindungen mit 2 oder mehr alkoholischen Hydroxygruppen, die primär oder sekundär sein können, bevorzugt. Geeignete Polyhydroxyverbindungen sind Diole wie 1,4-Butandiol und Triole wie Glycerin. Bevorzugte Polyhydroxyverbindungen haben ein Molekulargewicht von mindestens 100 und insbesondere von mehr als 500. Beispiele für geeignete Verbindungen mit einem Molekulargewicht in diesem Bereich sind Polyoxyalkylenglykole und -triole wie Polyoxyethylen-, Polyoxypropylen- sowie Polyoxytetramethylenglykole und -triole, Polyepichlorhydrine, Polycaprolactone mit endständigen Hydroxylgruppen, Polymere von Hydroxyalkylacrylaten und -methacrylaten, Copolymere von Allylalkohol mit einem Vinylmonomer wie Styrol, Polyvinylalkohole, Hydroxypropylcellulose und Hydroxygruppen enthaltende Polyvinylacetale.

Andere geeignete Polyhydroxyverbindungen sind Stoffe mit einem Gehalt an sekundären alkoholischen Hydroxygruppen, die durch Umsetzung eines Epoxidharzes (welches gegebenenfalls durch Vorverlängern eines Epoxidharzes niedrigen Molekulargewichts, insbesondere eines Polyglycidylethers eines mehrwertigen Phenols, beispielsweise durch Umsetzung mit einem zweiwertigen Phenol oder einer Dicarbonsäure erhältlich ist) mit einem Überschuss einer ein oder mehrere mit Epoxidgruppen reaktionsfähige Gruppen tragenden Verbindung, wie z. B. phenolische Hydroxyl-, Carboxyl-, primäre oder sekundäre Amino- oder Merkaptogruppen, erhalten werden. Weitere geeignete Polyhydroxyverbindungen sind phenolische Resole, d.h. durch die Reaktion eines Phenols mit einem Überschuss an Aldehyd hergestellte Harze, wie Phenolformaldehydresole. Soweit ein Phenolformaldehydresol als kationisch polymerisierbares Material (A) in einer erfindungsgemässen Zusammensetzung verwendet wird, muss die Hydroxyverbindung (B) in Form eines anderen Resols oder eine andere Verbindung als ein Resol anwesend sein.

Besonders bevorzugte Hydroxyverbindungen sind Styrol/Allylalkoholcopolymere, Phenol/Formaldehydresole und sekundäre alkoholische Hydroxygruppen enthaltende Harze, welche durch Reaktion eines Diglycidylethers des 2,2-Bis-(4-hydroxyphenyl)-propans, der seinerseits gegebenenfalls mit 2,2-Bis-(4-hydroxyphenyl)-propan vorverlängert sein kann, mit einem Überschuss eines ein- oder zweiwertigen Phenols, insbesondere Phenol oder 2,2-Bis-(4-hydroxyphenyl)propan, hergestellt werden.

Der Gehalt an Hydroxyverbindung (B) in den erfindungsgemässen Zusammensetzungen kann in einem weiten Bereich schwanken, je nachdem, wie verträglich die Hydroxyverbindung mit dem kationisch polymerisierbaren Material ist und welcher Art die geforderten physikalischen Eigenschaften im polymerisierten Produkt sind. Sofern Monohyoroxyverbindungen eingesetzt werden, ist ihr Gehalt im allgemeinen so bemessen, dass er 0,001 bis 0,2 Äquivalenten der Hydroxyverbindung pro Äquivalent des Epoxids oder eines anderen kationisch polymerisierbaren Materials entspricht, und bei Verwendung von Polyhydroxyverbindungen sind letztere in einer Menge vorhanden, die 0,001 bis 10 Äquivalenten der Hydroxyverbindung pro Äquivalent des kationisch polymerisierbaren Materials entspricht. Besonders geeignete Zusammensetzungen mit einem Gehalt an bevorzugten Polyhydroxyverbindungen weisen 0,8 bis 1,2 Äquivalente der Hydroxyverbindung pro Äquivalent des kationisch polymerisierbaren Materials auf.

In den Diaryljodosylsalzen gemäss Formel II sind die Reste $R^3$ und $R^4$ vorzugsweise gleich und gegebenenfalls substituierte mono-, di- oder trihomocyclische oder heterocyclische aromatische Gruppen. Beispiele für geeignete heterocyclische aromatische Gruppen sind Thienyl, Furyl, Pyridyl und Pyrazolylgruppen. Beispiele für geeignete tricyclische aromatische Gruppen sind Anthryl-, Phenanthryl- und Fluorenylgruppen, wobei geeignete mono- und dicyclische aromatische Gruppen Phenyl- und Naphthylreste und Gruppen der Formel

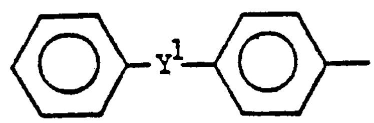 III

worin $Y^1$ eine Kohlenstoff-Kohlenstoffbindung, ein Ethersauerstoffatom oder eine Gruppe der Formel $-CH_2-$ oder $-C(CH_3)_2-$ ist, bedeuten. Jede dieser aromatischen Gruppen kann gegebenenfalls durch ein oder mehrere Atome oder Gruppen substituiert sein, die bei Bestrahlung oder Erhitzung des Salzes die Freisetzung einer Säureart nicht beeinträchtigen. Typische Vertreter dieser Substituenten sind Alkyl- und Alkoxygruppen mit 1 bis 4 Kohlenstoffatomen, Nitrogruppen und Halogenatome. Vorzugsweise sind $R^3$ und $R^4$ jeweils gegebenenfalls substituiertes Phenyl, insbesondere Phenyl oder durch eine Alkylgruppe mit 1 bis 4 Kohlenstoffatomen, insbesondere eine Methyl- oder Isopropylgruppe, ein Halogenatom, insbesondere ein Fluoratom oder eine Nitrogruppe substituiertes Phenyl.

Geeignete Anionen $Z^{x-}$ leiten sich ab von organischen Carbonsäuren, wie Acetat und Trifluoracetat oder von organischen Sulfonsäuren $Y-SO_3H$, worin Y eine gegebenenfalls einfach oder mehrfach durch Halogenatome substituierte aliphatische, aromatische oder aliphatisch-substituierte aromatische Gruppe mit vorzugsweise 1 bis 20 Kohlenstoffatomen ist, wie Methansulfonat, Benzolsulfonat, Toluol-p-sulfonat oder Trifluormethansulfonat und insbesondere von anorganischen Säuren, typischerweise von Halogeniden wie Fluorid, Chlorid und Bromid, Halogenaten wie Jodat, Perhalogenaten wie Perchlorat, sowie Nitrat, Sulfat, Hydrogensulfat, Phosphate, Hydrogenphosphate und komplexe Anionen wie Pentafluorohydroxoantimonat

und solche der Formel $MQ_w^-$, worin M für ein Metall- oder Metalloidatom und Q für ein Halogenatom stehen und w eine ganze Zahl von 4 bis 6 und um eins grösser als die Wertigkeit von M ist.

Die Anionen der Formel $MQ_w^-$ sind vorzugsweise Polyhalogenide des Antimons, Arsens, Bismuts, Eisens, Zinns, Bors und Phosphors, wie Hexafluoroantimonat, Hexachloroantimonat, Hexafluoroarsenat, Pentachlorobismutat, Tetrachloroferrat, Hexachlorostannat, Tetrafluoroborat oder Hexafluorophosphat, wobei die beiden letztgenannten besonders bevorzugt sind.

Jedes kationisch polymerisierbare Material lässt sich durch Bestrahlung oder Erhitzen in Gegenwart eines geeigneten Diaryljodosylsalzes der Formel II polymerisieren. Es wird jedoch nicht jedes solches Material durch jedes dieser Salze polymerisiert; die genaue Art des Materials und die des Anions $Z^{x-}$ ist dabei kritisch und muss zur Erzielung wirksamer Polymerisationsergebnisse ausgewählt werden. Die Abstimmung eines kationisch polymerisierbaren Materials mit einem geeigneten Anion gehört durchaus zum fachmännischen Wissen auf dem Gebiet der Härtung oder Polymerisierung kationisch polymerisierbarer Zusammensetzungen. Beispielsweise sind Salze mit einem Gehalt an Anionen, die sich von organischen Carbonsäuren, organischen Sulfonsäuren und anorganischen Säuren ableiten, insbesondere Acetate, Trifluoroacetate, Methansulfonate, Benzolsulfonate, Toluol-p-sulfonate, Trifluormethansulfonate, Fluoride, Chloride, Bromide, Jodate, Perchlorate, Nitrate, Sulfate, Hydrogensulfate, Phosphate oder Hydrogenphosphate, zur Härtung von Phenoplasten wie Phenol/Formaldehydharzen und Aminoplasten wie Harnstoff/Formaldehyd- und Melamin/Formaldehydharzen befähigt. Ein Metall- oder Metalloidhalogenidanion enthaltende Salze sind in der Lage, Epoxid- oder Episulfidharze zu härten oder Mono-1,2-epoxide, Monoepisulfide oder Vinylether zu polymerisieren. Weitere in Gegenwart eines Jodoniumsalzes durch Erhitzen oder Bestrahlung polymerisierbare Materialien lassen sich durch Bestrahlung in Anwesenheit eines geeigneten Diaryljodosylsalzes der Formel II oder durch Erwärmen in Anwesenheit eines solchen Salzes und eines Katalysators (D) dafür polymerisieren.

Die Menge des Diaryljodosylsalzes in den Zusammensetzungen ist gewöhnlich nicht kritisch, da lediglich katalytische Mengen notwendig sind, um Härtung oder Photopolymerisation einzuleiten. Im allgemeinen wird man 0,01 bis 10 bis 10 Gew.-%, vorzugsweise 0,5 bis 5 Gew.-%, bezogen auf das Gewicht des kationisch polymerisierbaren Materials (A), einsetzen.

Diaryljodosylsalze der Formel II sind analog einem Verfahren herstellbar, wie es von F.M. Beringer und P. Bodlaender, a.a.O. beschrieben ist. Ein Jodaren der Formel IV wird zum entsprechenden Jodoxyaren der Formel V unter Verwendung von Peressigsäure oxydiert. Das Behandeln von Jodoxyaren oder einem Gemisch aus zwei Jodoxyarenen, mit einem Alkalimetallhydroxid ergibt das Jodosylhydroxid der Formel VI, welches durch Behandlung mit Kohlendioxid in das Carbonat der Formel VII überführt werden kann. Dieses Hydroxid oder Carbonat wird mit einer Säure der Formel $H_xZ$ (soweit solche Säuren existieren) zur Bildung des gewünschten Salzes behandelt. (Unmittelbare Neutralisation des Jodosylhydroxids führt manchmal zu niedrigeren Ausbeuten des gewünschten Salzes als wenn es zuerst in das Carbonat überführt wird). Soweit solche Säuren nicht im freien Zustand existieren oder schwierig zu handhaben sind, kann das Hydroxid oder Carbonat beispielsweise mit Essig- oder Trifluoressigsäure zur Bildung des entsprechenden Acetats der Formel VIII oder Trifluoracetats der Formel IX behandelt werden. Ein solches Salz wird mit einem Alkalimetall oder Ammoniumsalz der Säure $H_xZ$, z. B. einem Phosphat, Hexafluorophosphat, Tetrachloroferrat oder Hexafluoroantimonat zur Erzielung des gewünschten Produkts der Formel II unter doppelter Zersetzung behandelt.

Diese Reaktionen werden durch das folgende Schema verdeutlicht:

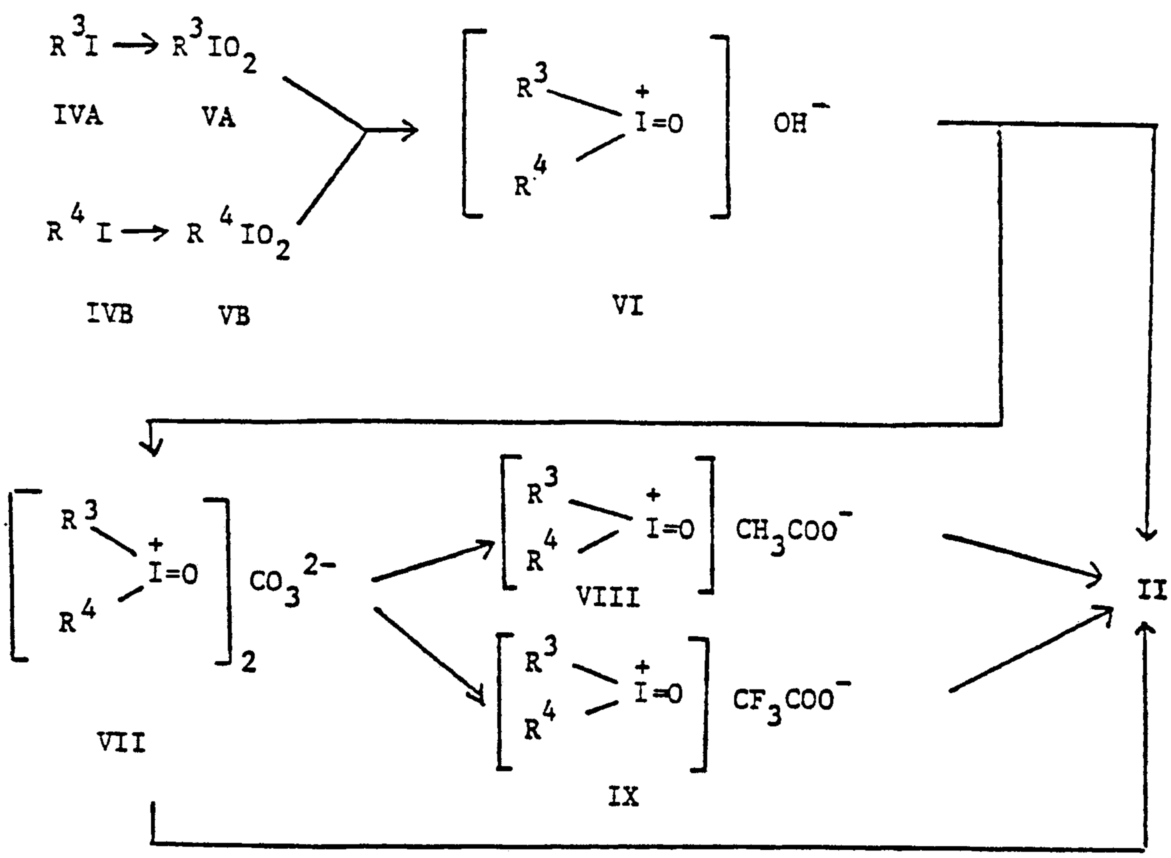

IVA VA IVB VB VI VII VIII IX II

Hexafluoroantimonate sind durch Zugabe von festem Natrium- oder Kaliumhexafluoroantimonat zu einer wässrigen Lösung des Jodosylacetats oder -trifluoracetats herstellbar: Wenn das Natrium- oder Kaliumsalz zuerst in Wasser aufgelöst wird, dann ist das isolierte Produkt aufgrund von Hydrolyse das Hydroxopentafluoroantimonat ($Z^{x-} = SbF_5(OH)^-$).

Sofern die erfindungsgemässen Zusammensetzungen photopolymerisiert werden sollen, enthalten sie gegebenenfalls noch einen photochemischen Radikalbildner oder einen Photosensibilisator. Es wurde nun gefunden, dass durch Einarbeitung solcher geeigneter Beschleuniger die Geschwindigkeit des Aushärtens weiter zunimmt, was die Anwendung kürzerer Belichtungszeiten und/oder schwächerer Strahlungsquellen gestattet. Besonders bevorzugte Radikalbildner sind aromatische Carbonylverbindungen. Diese sind zwar bereits für die Radikalpolymerisation von ethylenisch ungesättigten Verbindungen eingesetzt worden, doch ist es überraschend, dass sie die kationische Polymerisation beschleunigen.

Geeignete aromatische Carbonylverbindungen schliessen Ketale von aromatischen Diketonen, insbesondere Verbindungen der Formel

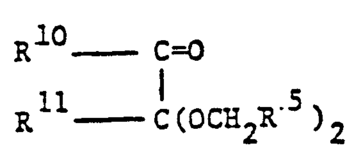

oder

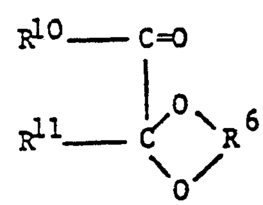

X XI

ein, worin $R^5$ ein Wasserstoffatom, eine Alkylgruppe mit 1 bis 5 Kohlenstoffatomen, eine Alkenylgruppe mit 2 oder 3 Kohlenstoffatomen eine Aralkylgruppe mit 7 bis 9 Kohlenstoffatomen oder eine. Aralkenylgruppe mit 8 oder 9 Kohlenstoffatomen, oder eine Gruppe der Formel $-(CH_2)_m R^7$ bedeutet, $R^6$ eine Gruppe der Formel $-CH_2CH(R^9)-$ oder $-CH_2CH(R^9)CH_2-$, $R^7$ ein Halogenatom oder eine Gruppe der Formel $-OR^8$, $-SR^8$, $-OR^{12}$, $-SR^{12}$, $-OCOR^8$ oder $-COOR^8$, m 1, 2 oder 3, $R^8$ eine Alkylgruppe mit 1 bis 4 Kohlenstoffatomen, $R^9$ ein Wasserstoffatom oder eine Alkylgruppe mit 1 bis 18 Kohlenstoffatomen sind und $R^{10}$, $R^{11}$ und $R^{12}$ unabhängig voneinander jeweils eine gegebenenfalls mit bis zu 3 Substituenten aus der Reihe der Halogenatome, Alkyl- oder Alkoxygruppen mit 1 bis 4 Kohlenstoffatomen und Phenylgruppen substituierte Phenylgruppe bedeuten.

Beispiele für Verbindungen der Formel X sind Benzildimethylketal, Benzildiethylketal, Benzildi-(2-methoxyethyl)ketal und Benzildi-(2-chlorethyl)-ketal. Beispiele für Verbindungen der Formel XI sind 2-Phenyl-2-benzoyl-4-methyl-1,3-dioxolan und 2-Phenyl-2-benzoyl-1,3-dioxan. Eine besonders bevorzugte aromatische Carbonylverbindung dieser Art is Benzildimethylketal.

Verbindungen der Formel X oder der Formel XI sind aus US-A-4 190 602 bekannt, wo sie für die Photopolymerisation und Photovernetzung von ethylenisch ungesättigten Verbindungen wie Methylacrylat, styrolhaltigen Polyestern auf Maleinsäurebasis und Diallylphthalatpräpolymeren eingesetzt werden.

Weitere als Photobeschleuniger geeignete Stoffe schliessen aromatisch-aliphatische Ketone einer der Formeln

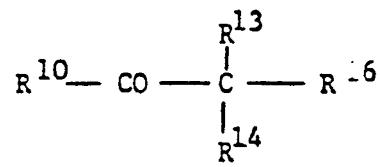

XII

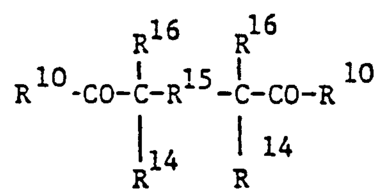

XIII

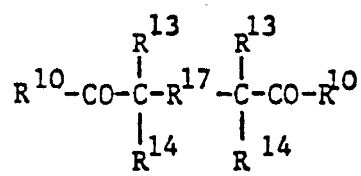

XIV

und

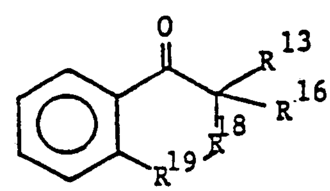

XV

ein, worin $R^{10}$ die oben bezeichnete Bedeutung aufweist, $R^{13}$ und $R^{14}$ jeweils eine einwertige aliphatische, cycloaliphatische oder araliphatische Gruppe bedeuten oder zusammen mit dem sie verknüpfenden Kohlenstoffatom eine Cycloalkylengruppe bilden, $R^{15}$ eine Kohlenstoff-Kohlenstoffbindung oder ein zweiwertiger organischer Rest ist, $R^{16}$ eine Hydroxy- oder Aminogruppe oder eine einwertige veretherte oder silylierte solche Gruppe darstellt, $R^{17}$ eine zweiwertige Amino-, Ether- oder Siloxygruppe, $R^{18}$ eine direkte chemische Bindung oder $-CH_2$ - und $R^{19}$ -O-, -S-, $-SO_2-$, $-CH_2-$oder $-C(CH_3)_2-$ bedeuten.

Diese Verbindungen, von denen bevorzugte Vertreter u.a. 2-Allyloxy-2-methylpropiophenon, 2-Benzyloxy-2-methylpropiophenon, 2-Hydroxy-2-methyl-p-phenoxypropiophenon, 1-Benzoylcyclohexanol, 1-Benzoylcyclopentanol und Bis-(4-(α-hydroxyisobutyryl)-phenyl)-ether darstellen, sind ebenfalls als Photopolymerisationskatalysatoren für ethylenisch ungesättigte Verbindungen und als Lichtvernetzer für Polyolefine aus US-A-4 308 400 bekannt.

Weitere Verbindungen, welche gegebenenfalls zur Erhöhung der Photopolymerisationsgeschwindigkeit der Salze der Formel II eingesetzt werden können, sind 2-substituierte Thioxanthone der Formel

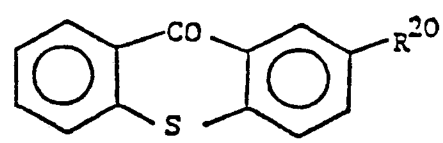

XVI

worin $R^2$ entweder ein Chloratom oder eine Alkylgruppe mit 1 bis 6 Kohlenstoffatomen, wie eine Isopropyl- oder tert.-Butylgruppe ist. Verbindungen der Formel XVI, insbesondere die 2-Chlorverbindung werden technisch als Photopolymerisationskatalysatoren für ethylenisch ungesättigte Verbindungen und als Lichtvernetzer für Polyolefine eingesetzt.

Wir setzen vorzugsweise 30 bis 125 Gew.-%, insbesondere 50 bis-100 Gew.%, an Photobeschleuniger,

bezogen auf das Gewicht des Diaryljodosylsalzes der Formel II, ein.

Die Zusammensetzungen können auch Photosensibilisatoren wie Polyarylen (beispielsweise Perylen und 9,10-Di-ethoxyanthracen), Polyarylpolyene, 2,5-Diarylisobenzofurane 2,5-Diarylfurane, 2,5-Diarylthiofurane,-2,5-Diarylpyrrole, 2,5-Diarylcyclopentadiene, Polyarylphenylene, Cumarin oder Polyaryl-2-pyrazoline enthalten.

Sofern die erfindungsgemässen Zusammensetzungen im wesentlichen durch Wärme allein polymerisiert werden solle, enthalten sie noch (D) ein Salz oder einen Komplex eines Übergangsmetalls, der ersten Übergangsreihe von Scandium bis Zink oder der zweiten Übergangsreihe von Ytterium bis Cadmium, ein Zinn-II-salz, ein organisches Peroxid oder eine aktivierte, beim Erhitzen auf eine Temperatur über 50°C freie Radikale bildende α-Hydroxyverbindung als Katalysator für das Jodosylsalz.

Als gegebenenfalls als Katalysator (D) in den erfindungsgemässen härtbaren Zusammensetzungen einsetzbare organische Peroxyde kommen u.a. Dicumylperoxyd, tert.-Butylperbenzoat, tert.-Butylperoxyd und insbesondere Benzoylperoxyd in Betracht. Ein bevorzugtes Zinn-II-salz ist Zinn-II-chlorid.

Der Katalysator (D) ist vorzugsweise ein Salz oder Komplex eines Übergangsmetalls der ersten Übergangsreihe von Scandium bis Zink oder der zweiten Übergangsreihe von Yttrium bis Cadmium oder eine aktivierte α-Hydroxyverbindung. Als bevorzugte Übergangsmetalle, deren Salze oder Komplexe als Katalysator (D) eingesetzt werden, sind Zink, Kobalt, Chrom, Eisen und als besonders bevorzugt Kupfer zu nennen. Die Salze können gegebenenfalls von organischen säuren oder Mineralsäuren hergeleitet sein, wie z. B. Chloride, Acetate Trichloracetate, Naphthenate, Octanoate und Oxalate. Geeignete Komplexe sind π-Orbitalkomplexe und solche, die aus innere Komplexe bildenden Liganden gebildet sind, wie Aldehyde, Ketone, Carboxamide oder aliphatische Aminomono- und -polycarbonsäuren. Besonders bevorzugte Komplexe sind solche, die aus 1,3-Diketonen wie Acetylaceton, oder dessen Homologen wie Benzoylaceton und seinen Derivaten wie Ethylacetoacetat gebildet sind.

Die aktivierte α-Hydroxyverbindung ist eine Verbindung mit einer Hydroxygruppe, die an ein Kohlenstoffatom in α-Stellung zu einer aktivierenden Gruppe wie z. B. einer Carbonylgruppe oder einem eine Hydroxygruppe tragenden Kohlenstoffatom gebunden ist, wobei die Verbindung beim Erhitzen freie Radikale liefert. Geeignete aktivierte α-Hydroxyverbindungen umfassen Ascorbinsäure, Ketone wie Acyloine und Benzoine sowie aktivierte Diole wie Pinakol und seine Homologen, insbesondere Benzpinakol.

Falls gewünscht, können bestimmte Katalysatoren (D) zusammen eingesetzt werden, wie zum Beispiel ein Salz oder Komplex eines Übergangsmetalls wie Kupferacetylacetonat oder Kupferbenzoat zusammen mit Ascorbinsäure oder Benzpinakol.

Die Menge an Katalysator (D) ist nicht kritisch, wird aber im allgemeinen im Bereich von 10 bis 150 Gew.-%, bezogen auf das Gewicht des verwendeten Diaryljodosylsalzes, liegen.

Weitere gegebenenfalls in die erfindungsgemässen Zusammensetzungen einarbeitbare Stoffe sind u.a. Verdünnungsmittel und Füllstoffe, wie Kieselsäure, Talkum, Glasmicroballoons Tone, Metallpulver oder Zinkoxyd, Viskositätsregler wie z. B. Asbest, Kautschuksorten, Klebrigmacher und Pigmente.

Bei Belichtung einer erfindungsgemässen Zusammensetzung mit Strahlung geeigneter Wellenlänge wird das als Photoinitiator agierende Jodosylsalz offensichtlich durch Freisetzen einer Art saurer Verbindung aktiviert, was die Polymerisation und, sofern die Zusammensetzung ein härtbares kationisch polymerisierbares Material wie ein Epoxid- oder Phenolharz enthält, auch die Vernetzung der Zusammensetzung herbeiführt. Bei der im erfindungsgemässen Verfahren verwendeten Strahlung kann es sich ausschliesslich um Ultraviolettstrahlung oder gegebenenfalls auch um Strahlung mit Wellenlängen sowohl im ultravioletten als auch im sichtbaren Spektralbereich handeln. Die Zusammensetzungen können auch Farbstoffe enthalten, damit sie auf sichtbare Spektralbereiche ansprechen. Geeignete Farbstoffe sind zum Beispiel aus US-A-4 026 705 bekannt; es handelt sich dabei im allgemeinen um kationische Farbstoffe wie Acridingelb, Acridinorange, Phosphin R, Benzoflavin, Setoflavin T und ihre Gemische.

Die bevorzugte Wellenlänge der im erfindungsgemässen Verfahren angewandten Strahlung liegt im Bereich von 200 bis 600 nm, insbesondere 200 bis 400 nm. Die Wahl der geeigneten Strahlungsquelle unter den handelsüblichen Geräten, welche Strahlung innerhalb des vorstehend genannten Wellenlängenbereichs aussenden, ist eine Routinemassnahme für Fachleute auf dem Gebiet der Photopolymerisation.

Die einen Katalysator (D) enthaltenden erfindungsgemässen Zusammensetzungen werden beim Erhitzen auf eine Temperatur über 50°C, vorzugsweise auf eine Temperatur im Bereich von 80°bis 180°C, rasch polymerisiert. Die Zusammensetzungen werden gegebenenfalls 1 bis 200, vorzugsweise 1 bis 30, Minuten lang erhitzt.

Wenn die erfindungsgemässen Zusammensetzungen ein härtbares kationisch polymerisierbares Material, inbesondere ein Epoxidharz oder ein Phenoplast enthalten, können sie durch Bestrahlung vor- und dann durch Erhitzen ausgehärtet werden. Für einen zweistufigen Härtungsprozess enthält die Zusammensetzung entweder einen die Heisshärtung durch das Jodosylsalz beschleunigenden Katalysator (D) oder einen anderen hitzeaktivierbaren Härter für das härtbare Material. Derartige hitzeaktivierbare Härter sind bekannt, und es gehört zum Routinewissen des Fachmanns auf dem Gebiet der Härtungsverfahren, einen für das jeweils spezifische härtbare Material geeigneten Härter auszuwählen. Falls es erwünscht ist, das vorgehärtete Material für einen nachfolgenden Heisshärtungsprozess aufzubewahren, ist es selbstverständlich von Bedeutung, die Belichtung bei einer Temperatur auszuführen, die unterhalb der Temperatur liegt, bei welcher wesentliche Heisshärtung des photopolymerisierten Produkts mittels des Heisshärters eintreten würde.

Somit sind die erfindungsgemässen Zusammensetzungen mit einem Gehalt an Epoxidharzen oder Phenoplasten in zwei Stufen härtbar. Falls das Phenoplast ein nicht unter der Einwirkung des Jodosylsalzes

polymerisierbarer Novolak ist, wird es zusammen mit einem unter dessen Einwirkung poymerisierbaren Material wie einem Epoxidharz oder einem cyclischen Vinylether eingesetzt. Die Zusammensetzung wird zunächst durch aktinische Bestrahlung in Gegenwart eines latenten, hitzeaktivierbaren Vernetzers für das Epoxidharz oder Phenoplast (wahlweise, wenn das Phenoplast ein Resol ist) in den vorgehärteten B-Zustand gebracht, und in einer zweiten Stufe wird die vorgehärtete Zusammensetzung zur Vervollständigung der Härtung erwärmt. Demgemäss ist eine flüssige oder halbflüssige Zubereitung herstellbar, die anschliessend geformt oder zur Tränkung eines unter Belichtung zu verfestigenden Substrats verwendet werden kann; der verfestigte Körper kann danach gewünschtenfalls zur Aushärtung des Harzes erhitzt werden.

Geeignete hitzeaktivierbare Vernetzer für Epoxidharze schliessen Polycarbonsäureanhydride, Aminkomplexe, insbesondere solche von primären oder tertiären aliphatischen Aminen wie Ethylamin, Trimethylamin oder n-Octyldimethylamin mit Bortrifluorid oder Bortrichlorid sowie latente Bordifluoridchelate ein. Aromatische Polyamine und Imidazole sind im allgemeinen nicht bevorzugt, da mässige Resultate erhalten werden, möglicherweise aufgrund einer Reaktion zwischen dem freigesetzten sauren Katalysator und dem Amin. Dicyandiamid lässt sich erfolgreich einsetzen, vorausgesetzt, dass es in verhältnismässig groben Teilchen vorliegt.

Geeignete hitzeaktivierbare Vernetzer für Novolake umfassen Hexamethylentetramin und Paraformaldehyd.

Die für die Heisshärtung nach der Photopolymerisation benötigte Temperatur und Erhitzungsdauer sowie die Anteile an hitzeaktivierbarem Härter sind leicht durch routinemässiges Ausprobieren herauszufinden und in einfacher Weise vom Stand der Technik auf dem Gebiet der Heisshärtung von Epoxid- und Phenol/Aldehydharzen abzuleiten.

Zusammensetzungen mit einem Gehalt an Harzen mit Epoxidgruppen oder phenolischen Hydroxygruppen, durch welche sie nach der Photopolymerisation heissgehärtet werden können, sind besonders bei der Herstellung von mehrschichtigen gedruckten Schaltungen brauchbar.

Die erfindungsmässen Zusammensetzungen sind als Oberflächenbeschichtungen verwendbar. Sie können auf eine Unterlage wie Stahl, Aluminium, Kupfer, Cadmium, Zink, Papier oder Holz, vorzugsweise als Flüssigkeit, aufgebracht und danach belichtet oder erhitzt werden. Beim abschnittsweisen Photopolymeriseren der Beschichtung wie z. B bei Belichtung durch eine Maske hindurch, können die unbelichteten Stellen mit einem Lösungsmittel zur Entfernung der nichtpolymerisierten Anteile ausgewaschen werden, wobei die photopolymerisierten unlöslichen Anteile an Ort und Stelle verbleiben. Demgemäss können die erfindungsgemässen Zusammensetzungen bei der Herstellung von Druckplatten und gedruckten Schaltungen Verwendung finden. Die Verfahren zur Herstellung von Druckplatten und gedruckten Schaltungen aus photopolymerisierbaren Zusammensetzungen sind wohlbekannt.

Die Zusammensetzungen sind auch als Klebstoffe einsetzbar. Eine Schicht der Zusammensetzung kann zwischen zwei Oberflächen von Gegenständen eingebracht werden und danach kann der Aufbau zur vollständigen Polymerisation belichtet und/oder erhitzt werden. Beim Photopolymerisieren ist es selbstverständlich notwendig, dass wenigstens einer der Gegenstände aus Glas oder einem anderen für aktinische Strahlung durchlässigen Material besteht.

Die Zusammensetzungen sind auch bei der Herstellung faserverstärkter Verbundstoffe einschliesslich Schichtformmassen brauchbar.

Sie können direkt, kontinuierlich oder chargenweise in flüssiger Form auf Verstärkungsfasern (einschliesslich Spinn- oder Endlosfäden und Whisker) aufgebracht werden, die als Gewebe oder Vlies, unidirektionelle Längen, geschnittene Spinnfäden, insbesondere aus Glas, Bor, Edelstahl, Wolfram, Aluminiumoxid, Siliciumcarbid, Asbest, Kaliumtitanatwhisker, aromatischem Polyamid wie Poly-(m-phenylenisophthalamid), Poly(p-phenylenterephthalamid) oder Poly-(p-benzamid), Polyethylen, Polypropylen oder Kohlenstoff vorliegen können. Wenn die Zusammensetzung ein heisshärtbares Material wie ein Epoxidharz enthält, kann das getränkte Fasermaterial zur Photopolymerisation belichtet werden und auf diese Weise die Zusammensetzung unter Bildung eines Präpregs verfestigt und dieser gegebenenfalls unter Druck wahlweise zusammen mit anderen Präpregs oder Faserschichten, zur Herstellung eines gehärteten faserverstärkten Verbundstoffs erhitzt werden.

Die erfindungsgemässen Zusammensetzungen sind bei der Herstellung von Kitten und Füllstoffen verwendbar. Man kann sie für Tauchbeschichtungen einsetzen, wobei ein zu beschichtender Gegenstand in die flüssige Zusammensetzung eingetaucht, wieder herausgenommen und danach die anhaftende Beschichtung zur Photopolymerisation (und somit zur Verfestigung) bestrahlt und daran anschliessend gegebenenfalls erhitzt wird.

Bei einer weiteren Anwendung wird eine Schicht der Zusammensetzung in flüssiger Form bestrahlt, bis sie sich unter Bildung eines Klebfilms verfestigt, welcher dann zwischen zwei zu verklebende Flächen und in Berührung mit diesen eingelegt wird, worauf man den Aufbau zur vollständigen Vernetzung der Zusammensetzung erhitzt. Der Film kann dabei auf einer Seite mit einer abziehbaren Schutzfolie, beispielsweise aus einem Polyolefin oder Polyester oder aus cellulosehaltigem Papier mit einer Silicontrennmittelbeschichtung versehen sein. Der Aufbau ist häufig leichter zu handhaben, wenn der Film eine klebrige Oberfläche aufweist. Dies lässt sich dadurch erreichen, dass man den Film mit einer bei Raumtemperatur klebrigen Substanz beschichtet, welche jedoch unter den zur vollständigen Vernetzung angewandten Erhitzungsbedingungen zu einem harten, unlöslichen und unschmelzbaren Harz vernetzt. Ein hinreichendes Mass an Klebrigkeit besteht jedoch häufig ohne zusätzliche Behandlung, insbesondere dann, wenn die Polymerisation der Zusammensetzung nicht zu weit fortgeschritten ist. Geeignete Klebsubstrate sind

unter anderem Metalle wie Eisen, Zink, Kupfer, Nickel und Aluminium, Keramik, Glas und Kautschukarten.

Die nachfolgenden Beispiele erläutern die Erfindung, wobei Teile stets Gewichtsteile sind.

Jodosylsalze werden wie folgt hergestellt:

Jodoxybenzol (4,72 g) wird unter kräftigem Rühren zu 1-normaler wässriger Natronlauge (40 ml) bei 0°C hinzugefügt. Nach 2 Stunden wird das ausgefallene Natriumjodat durch Filtration entfernt, und man lässt Kohlendioxid durch das Filtrat hindurchperlen, bis die Lösung neutral ist. Man fügt langsam 1-normale Essigsäure zum Freisetzen des Kohlendioxyds in geringem Überschuss hinzu. Diphenyljodosylacetatmonohydrat wird als weisser Feststoff mit einem Schmelzpunkt von 105-110°C (Zersetzung) abfiltriert; man erhält 2,76 g.

Das so erhaltene Monohydrat (1,87 g) wird in siedendem Wasser (25 ml) aufgelöst. Die Lösung wird mit Entfärbungskohle behandelt und heiss filtriert. Eine gesättigte wässrige Kaliumhexafluorophosphatlösung wird dann langsam hinzugefügt, bis keine weitere Fällung mehr erfolgt. Danach wird die Mischung gekühlt und filtriert. Der Rückstand wird über Phosphorpentoxyd im Vakuum bei Raumtemperatur getrocknet und man erhält Diphenyljodosylhexafluorophosphat (0,87 g) mit einem Schmelzpunkt von 120-130°C (Zersetzung).

Man gibt Jodoxybenzol (35,4g) bei 0°C unter kräftigem Rühren zu 1-normaler Natronlauge (300 ml). Nach 2 Stunden wird das Gemisch filtriert und Kohlendioxyd durch das Filtrat so lange hindurchgeperlt, bis die Lösung neutral ist. Ein Teil dieser Carbonatlösung (100 ml) wird langsam mit Fluorborsäure (40 %) versetzt, bis die Entwicklung von Kohlendioxyd aufhört. Eine weitere Menge an Säure (2 ml) wird danach hinzugefügt und der Niederschlag abfiltriert. Dieser wird mit Eiswasser gewaschen und dann getrocknet; man erhält Diphenyljodosyltetrafluoroborat (2,4 g) mit einem Schmelzpunktbereich von 110-120°C (Zersetzung).

Bis-(4-methylphenyl)jodosyltrifluoracetat (1,16 g; nach der Vorschrift von F.M. Beringer und P. Bodlaender, a.a.O. hergestellt) wird in siedendem Wasser (10 ml) aufgelöst und filtriert; das Filtrat wird mit Kaliumhexafluorophosphat (0,49 g) als gesättigte wässrige Lösung behandelt. Das Gemisch wird auf etwa die Hälfte seines Volumens eingeengt und der Niederschlag abfiltriert. Dieser wird darauf getrocknet und ergibt Bis-(4-methylphenyl)jodosylhexafluorophosphat (0,68 g) mit einem Schmelzpunkt von 125°C (Zersetzung).

Bis-(2-methylphenyl)jodosyltrifluoroacetat (0,7 g; nach der Vorschrift von F.M. Beringer und P. Bodlaender a.a.O. hergestellt) wird in siedendem Wasser (25 ml) aufgelöst und mit Kaliumhexafluorophosphat (0,45 g) in Wasser (5 ml) versetzt. Die so erhaltene Lösung wird abgekühlt, und der sich bildende Niederschlag durch Filtrieren gesammelt und getrocknet; man erhält Bis-(2-methylphenyl)jodosylhexafluorophosphat (0,4 g) mit einem Schmelzpunkt von 148-150°C (Zersetzung).

Diphenyljodosyltrifluoracetat (1,2 g; gemäss F.M. Beringer und P. Bodlaender a.a.O., hergestellt) wird in heissem Wasser aufgelöst, mit Aktivkohle behandelt und heiss abfiltriert. Eine wässrige Lösung von Kaliumhexafluoroarsenat (0,7 g) wird zum Filtrat hinzugegeben und die erhaltene Lösung abgekühlt. Der weisse sich bildende Niederschlag wird durch Filtrieren gesammelt un an der Luft getrocknet; man erhält Diphenyljodosylhexafluoroarsenat (0,64 g) mit einem Schmelzpunkt von 135-138°C (Zersetzung).

Die in den Beispielen verwendeten Harze sind die folgenden:

Harz 1 ist 3,4-Epoxicyclohexancarbonsäure-3',4'-epoxicyclohexylmethylester mit einem 1,2-Epoxidgehalt von 7,3 val/kg.

Harz 2 ist ein Styrol/Allylalkoholcopolymer mit einem Molekulargewicht von 2340 und einem Hydroxygehalt von 3,56 val/kg; letzteres ist im Handel als "RJ 100" von Monsanto Chemical Company erhältlich.

Harz 3 ist 3,4-Dihydro-2H-pyran-2-carbonsäure-3,4-dihydro-2H-pyran-2-ylmethylester.

Harz 4 ist ein Diglycidylether des 2,2-Bis-(4-hydroxyphenyl)-propans mit einem 1,2-Epoxidgehalt von 5,2 val/kg.

Harz 5 ist ein 1,4-Butandioldiglycidylether mit einem 1,2-Epoxidgehalt von 9,3 val/kg.

Harz 6 ist ein Harz mit Bisphenolendgruppen, welches durch Umsetzung eines Diglycidylethers des 2,2-Bis-(4-hydroxyphenyl)propans mit 2,2-Bis-(4-hydroxyphenyl)propan bis zu einem durchschnittlichen Molekulargewicht von 1820 erhalten wird.

Harz 7 ist Bis-(3,4-epoxicyclohexylmethyl)adipat mit einem 1,2-Epoxidgehalt von 4,8 val/kg.

Harz 8 ist ein mit 4-Toluolsulfonsäure neutralisiertes Phenol/Formaldehydresol mit einem Phenol: Formaldehydverhältnis von 1 : 1,14, einer Viskosität von 0,7 Pa.s bei 25°C und einem Feststoffgehalt von 76 %.

## BEISPIEL 1

Man beschichtet Weissblech mit einem Gemisch aus Harz 1 (100 Teile), Harz 2 (100 Teile) und Diphenyljodosylhexafluorophosphat (6 Teile) in einer Schichtdicke von 8-10 µm. 2 Sekunden Bestrahlung des Films mit einer 80 W/cm Mitteldruckquecksilberlampe in einem Abstand von 20 cm ergitt eine klebfreie Beschichtung.

**BEISPIEL 2**

Man vermischt Harz 1 (30 Teile), Harz 2 (100 Teile), Harz 4 (50 Teile), Harz 5 (20 Teile) und Diphenyljodosylhexafluorophosphat (6 Teile) und streicht das Gemisch auf Weissblech in einer Schichtdicke von 6-8 µm. Man bestrahlt wie in Beispiel 1 angegeben und erhält innerhalb von 3 Sekunden eine klebfreie Beschichtung.

**BEISPIEL 3**

Man beschichtet Weissblech mit einer Mischung aus Harz 2 (100 Teile), Harz 3 (100 Teile) und Bis-(4-methylphenyl)jodosylhexafluorophosphat (6 Teile) in einer Schichtdicke von 6-8 µm. Man bestrahlt wie in Beispiel 1 angegeben und erhält innerhalb von 25 Sekunden eine klebfreie Oberfläche.

**BEISPIEL 4**

Man beschichtet Weissblech mit einem Gemisch aus Harz 6 (37,5 Teile), Harz 1 (62,5 Teile) und Diphenyljodosylhexafluoroarsenat (2 Teile) in einer Schichtdicke von 8-10 µm. Man bestrahlt wie in Beispiel 1 angegeben und erhält innerhalb von 3 Sekunden eine klebfreie Beschichtung.

**BEISPIEL 5**

Man beschichtet Weissblech mit einer Mischung aus Harz 6 (50 Teile), Harz 7 (50 Teile) und Diphenyljodosyltetrafluoroborat (5 Teile) in einer Schichtdicke von 6-8 µm. Man bestrahlt wie in Beispiel 1 angegeben und erhält innerhalb von 30 Sekunden eine klebfreie Beschichtung.

**BEISPIEL 6**

Man beschichtet Weissblech mit einem Gemisch aus Harz 7 (50 Teile), Harz 8 (50 Teile) und Diphenyljodosylhexafluorophosphat (3 Teile) in einer Schichtdicke von 6-8 µm und bestrahlt in derselben Weise wie in Beispiel 1 angegeben. Innerhalb von 8 Sekunden wird eine klebfreie Beschichtung erhalten.

**BEISPIEL 7**

Auf der Koflerbank wird eine Mischung aus Harz 1 (100 Teile), Harz 2 (100 Teile), Diphenyljodosylhexafluorophosphat (6 Teile) und Kupfer-II-trichloracetat (2 Teile) erhitzt. Es vergehen 15 Minuten bei einer Temperatur von 120°C, bis Gelierung eintritt.

**BEISPIEL 8**

Eine Mischung aus Harz 2 (100 Teile), Harz 4 (50 Teile), Harz 1 (30 Teile) und Harz 5 (20 Teile) mit Diphenyljodosylhexafluorophosphat (3 Teile) und Kupfer-II-acetylacetonat (1 Teil) wird auf der Koflerheizbank bei 120°C erhitzt. Es wird eine Gelierungszeit von 3 1/2 Minuten beobachtet.

**BEISPIEL 9**

Es wird auf der Koflerheizbank ein Gemisch aus Harz 1 (62,5 Teile) und Harz 6 (37,5 Teile) mit Diphenyljodosylhexafluoroarsenat (3 Teile) und Zinn-II-chlorid bei 180°C erhitzt. Es wird eine Gelierungszeit von 6 Minuten beobachtet.

**BEISPIEL 10**

Man erhitzt ein Gemisch aus Harz 6 (50 Teile), Harz 7 (50 Teile), Diphenyljodosyltetrafluoroborat (5 Teile) und Benzoylperoxyd (1 Teil) auf der Koflerheizbank bei 150°C. Es ergibt sich eine Gelierungszeit von 90 Sekunden.

**BEISPIEL 11**

Man beschichtet Weissblech mit einem Gemisch aus Harz 2 (50 Teile) und Harz 3 (50 Teile) mit Bis-(4-methylphenyl)jodosylhexafluorophosphat (3 Teile) und 2-Isopropyl-thioxanthon (1 Teil) in einer Filmdicke von 6-8 µm. Bestrahlung des Films mit einer 80 W/cm Mitteldruckquecksilberlampe in einem Abstand von 20 cm ergibt innerhalb von 15 Sekunden eine klebfreie Oberfläche.

**BEISPIEL 12**

Man beschichtet Weissblech mit einem Gemisch aus Harz 2 (50 Teile), Harz 3 (50 Teile), Bis-(2-methylphenyljodosylhexafluorophosphat (3 Teile) und 2-Isopropylthioxainthon (1 Teil) in einer Schichtdicke von 6-8 µm. Man bestrahlt wie in Beispiel 11 angegeben und erhält innerhalb von 20 Sekunden eine klebfreie Oberfläche.

**Patentansprüche**

1. Polymerisierbare Zusammensetzungen enthaltend
(A) ein kationisch polymerisierbares Material,
(B) eine epoxidfreie organische Hydroxyverbindung mit mindestens einer alkoholischen Hydroxygruppe, ausschliesslich solcher Hydroxyverbindungen, welche beim Erhitzen auf über 50°C freie Radikale bilden und
(C) ein aromatisches Jodosylsalz der Formel

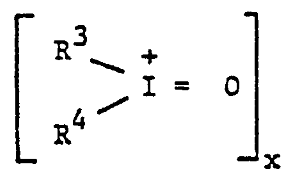 $Z^{x-}$ II

worin $R^3$ und $R^4$ gleich oder verschieden sein können und jeweils einen einwertigen aromatischen Rest mit 4 bis 25 Kohlenstoffatomen bedeuten, x 1, 2 oder 3 ist, und $Z^{x-}$ ein $x^-$, wertiges Anion einer Protonensäure bedeutet.

2. Zusammensetzungen nach Anspruch 1, worin (A) ein cycloaliphatisches Epoxidharz, ein gegebenenfalls vorverlängerter Polyglycidylether eines mehrwertigen Alkohols oder Phenols, ein cyclischer Vinylether mit einem Dihydropyranrest oder ein Phenol/Formaldehydresol darstellt.

3. Zusammensetzungen nach Anspruch 1 oder 2, worin (B) 2 oder mehr primäre oder sekundäre alkoholische Hydroxygruppen enthält und ein Molekulargewicht von mindestens 100 aufweist.

4. Zusammensetzungen nach Anspruch 3, worin (B) ein Polyoxyalkylenglykol oder -triol, ein Polyepichlorhydrin, Polycaprolacton mit endständigen Hydroxygruppen, ein Hydroxyalkylacrylat- oder Hydroxyalkylmethacrylatpolymer, ein Copolymer aus Allylalkohol mit einem Vinylmonomer, ein Polyvinylalkohol, eine Hydroxypropylcellulose, ein Hydroxygruppen enthaltendes Polyvinylacetal, ein durch Umsetzung eines Epoxidharzes mit einer eine oder mehrere gegenüber Epoxidgruppen reaktionsfähigen Gruppen enthaltenden Verbindungen im Überschuss erhaltenes Harz oder ein phenolisches Resol ist.

5. Zusammensetzungen nach einem der Ansprüche 1 bis 4, worin die Reste $R^3$ und $R^4$ gegebenenfalls substituierte Phenylgruppen sind.

6. Zusammensetzungen nach einem der Ansprüche 1 bis 5, worin sich das Anion $Z^{x-}$ von einer organischen Carbonsäure, einer organischen Sulfonsäure $Y\text{-}SO_3H$, worin Y eine aliphatische, aromatische oder aliphatisch substituierte aromatische Gruppe ist, wobei jede Gruppe gegebenenfalls durch ein oder mehrere Halogenatome substituiert sein kann oder einer anorganischen Säure ableitet.

7. Zusammensetzungen nach Anspruch 6, worin als Anion $Z^{x-}$ ein Acetat, Trifluoracetat, Methansulfonat, Benzolsulfonat, p-Toluolsulfonat, Trifluormethansulfonat, Fluorid, Chlorid, Bromid, Jodat, Perchlorat, Nitrat, Sulfat, Hydrogensulfat, Phosphat, Hydrogenphosphat oder Pentafluorohydroxoantimonat oder ein Anion der Formel $MQ_w^-$, worin M für ein Metall- oder Metalloidatom und Q für ein Halogenatom stehen und w eine ganze Zahl von 4 bis 6 und um eins grösser als die Wertigkeit von M ist, vorliegt.

8. Zusammensetzungen nach Anspruch 7, worin das Anion $Z^{x-}$ ein Hexafluoroantimonat,

Hexachloroantimonat, Hexafluoroarsenat, Pentachlorobismutat, Tetrachloroferrat, Hexachlorostannat, Tetrafluoroborat oder Hexafluorophosphat ist.

9. Photopolymerisierbare Zusammensetzungen nach einem der vorstehenden Ansprüche, enthaltend zusätzlich noch einen photochemischen Radikalbildner oder Photosensibilisator.

10. Hitzepolymerisierbare Zusammensetzungen nach einem der Ansprüche 1 bis 8, enthaltend zusätzlich noch (D) ein Salz oder einen Komplex eines Übergangsmetalls der ersten Übergangsreihe von Scandium bis Zink oder der zweiten Übergangsreihe von Yttrium bis Cadmium, ein Zinn-II-salz, ein organisches Peroxyd oder eine beim Erwärmen auf eine Temperatur über 50°C freie Radikale bildende aktivierte k-Hydroxyverbindung als Katalysator für das Jodosylsalz.

11. Zusammensetzungen nach Anspruch 10, worin (D) Dicumylperoxyd, tert.-Butylperbenzoat, tert.-Butylperoxyd, Benzoylperoxyd oder ein Salz bzw. Komplex von Zink, Kobalt, Chrom, Eisen oder Kupfer ist.

12. Verfahren zur Herstellung eines polymeren Materials, gekennzeichnet durch folgende Schritte:

(i) Bestrahlen einer Zusammensetzung nach Anspruch 1 mit Strahlung einer das Jodosylsalz aktivierenden Wellenlänge und/oder

(ii) Erhitzen auf über 50°C der Zusammensetzung nach Anspruch 1 oder der Zusammensetzung erhalten durch Bestrahlen der Zusammensetzung nach Anspruch 1 in Anwesenheit (D) eines Salzes oder Komplexes eines Übergangsmetalls der ersten Übergangsreihe von Scandium bis Zink oder der zweiten Übergangsreihe von Yttrium bis Cadmium, eines Zinn-II-salzes, eines organischen Peroxyds oder einer aktivierten, beim Erhitzen auf eine Temperatur über 50°C freie Radikale bildenden α-Hydroxyverbindung, als Katalysator für Jodosylsalz, bis die Zusammensetzung polymerisiert ist.

## Claims

1. A polymerisable composition comprising

(A) a cationically polymerisable material,

(B) an epoxide-free organic hydroxy compound having at least one alcoholic hydroxyl group, other than such a hydroxy compound which forms free radicals on heating at a temperature above 50°C, and

(C) an aromatic iodosyl salt of the formula

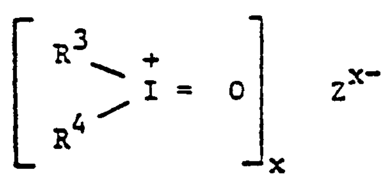

II

wherein

$R^3$ and $R^4$, which may be the same or different, each represent a monovalent aromatic radical having from 4 to 25 carbon atoms,

x denotes 1, 2 or 3, and

$Z^{x-}$ denotes an x-valent anion of a protic acid.

2. A composition according to Claim 1, in which (A) is a cycloaliphatic epoxide resin, a polyglycidyl ether, which may have been advanced, of a polyhydric alcohol or polyhydric phenol, a cyclic vinyl ether containing a dihydropyran residue, or a phenol-formaldehyde resol.

3. A composition according to Claim 1 or 2, in wich (B) has 2 or more primary or secondary alcoholic hydroxyl groups and a molecular weight of at least 100.

4. A composition according to Claim 3, in which (B) is a polyoxyalkylene glycol or triol, a polyepichlorohydrin, a hydroxyl-terminated polycaprolactone, a polymer of a hydroxyalkyl acrylate or a hydroxyalkyl methacrylate, a copolymer of allyl alcohol with a vinyl monomer, a polyvinyl alcohol, a hydroxypropylcellulose, a hydroxyl-containing polyvinyl acetal, a resin obtained by reacting an epoxide resin with an excess of a compound containing one or more groups reactive with epoxide groups, or a phenolic resol.

5. A composition according to any one of Claims 1 to 4, in which the radicals $R^3$ and $R^4$ are optionally substituted phenyl groups.

6. A composition according to any one of Claims 1 to 5, in which the anion $Z^{x-}$ is derived from an organic carboxylic acid, an organic sulphonic acid $Y\text{-}SO_3H$, where Y is an aliphatic, aromatic or aliphatic-substituted aromatic group, any of which groups may be substituted by one or more halogen atoms, or from an inorganic acid.

7. A composition according to Claim 6, in which the anion $Z^{x-}$ is an acetate, trifluoroacetate, methanesulphonate, benzenesulphonate, toluene-p-sulphonate, trifluoromethanesulphonate, fluoride, chloride, bromide, iodate, perchlorate, nitrate, sulphate, hydrogen sulphate, phosphate, hydrogen phosphate, pentafluorohydroxoantimonate or is an anion of formula $MQ_w^-$ where M represents an atom of a metal or metalloid, Q represents a halogen atom, and w is an integer of from 4 to 6 and is one more than the valency of M.

8. A composition according to Claim 7, in which the anion $Z^{x-}$ is a hexafluoroantimonate, hexachloroantimonate, hexafluoroarsenate, pentachlorobismuthate, tetrachloroferrate, hexachlorostannate, tetrafluoroborate, or hexafluorophosphate.

9. A phoytopolymerisable composition according to any one of the preceding Claims, which also contains a photochemical free radical former or a photosensitiser.

10. A heat-polymerisable composition according to any one of Claims 1 to 8, which also contains, as a catalyst for the iodosyl salt, (D) a salt or complex of a transition metal from the first transition series from scandium to zinc or from the second transition series from yttrium to cadmium, a tin (II) salt, or organic peroxide, or an activated α-hydroxy compound which forms free radicals on heating to a temperature above 50°C.

11. A composition according to Claim 10, in which (D) is dicumyl peroxide, tert.butyl perbenzoate, tert.butyl peroxide, benzoyl peroxide, or a salt or complex of zinc, cobalt, chromium, iron or copper.

12. A process for the preparation of polymeric material which comprises

(i) irradiating a composition according to Claim 1 with radiation of a wavelength such as to activate the iodosyl salt, and/or

(ii) heating the composition according to Claim 1 or the composition obtained by irradiating the composition according to Claim 1 to above 50°C in the presence, as catalyst for the iodosyl salt, of (D) a salt or complex of a transition metal from the first transition series from scandium to zinc or from the second transition series from yttrium to cadmium, a tin (II) salt, an organic peroxide or an activated α-hydroxy compound which forms free radicals on heating at a temperature above 50°C until the composition is polymerised.

**Revendications**

1. Compositions polymérisables qui contiennent:

(A) une matière polymérisable par voie cationique,

(B) un composé hydroxylique organique dépourvu de radical époxy et contenant au moins un radical hydroxy alcoolique, sauf les composés hydroxyliques qui, lorsqu'ils sont chauffés à plus de 50°C, donnent naissance à des radicaux libres, et

(C) un sel d'iodosyle aromatique répondant à la formule II:

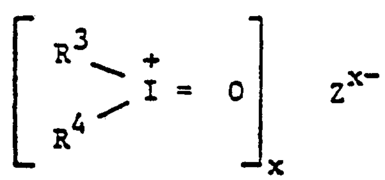

II

dans laquelle $R^3$ et $R^4$ représentent chacun, indépendamment l'un de l'autre, un radical aromatique univalent contenant de 4 à 25 atomes de carbone, x désigne un nombre égal à 1, à 2 ou à 3 et $Z^{x-}$ représente un anion de valence x provenant d'un acide protonique.

2. Compositions selon la revendication 1 dans lesquelles (A) est une résine époxydique cycloaliphatique, un éther polyglycidylique, éventuellement pré-allongé, d'un polyol ou d'un polyphénol, un éther vinylique cyclique contenant un radical de dihydropyranne, ou un résol phénol/ formaldéhyde.

3. Compositions selon l'une des revendications 1 et 2 dans lesquelles (B) contient 2 ou plus de 2 radicaux hydroxy alcooliques primaires ou secondaires et a une masse moléculaire d'au moins 100.

4. Compositions selon la revendication 3 dans lesquelles (B) est un poly-(oxy-alkylène)-glycol ou -triol, une poly-épichlorhydrine, une polycaprolactone à radicaux hydroxy terminaux, un polymère d'acrylate d'hydroxy-alkyle ou de méthacrylate d'hydroxy-alkyle, un copolymère de l'alcool allylique avec un monomère vinylique, un poly(alcool vinylique), une hydroxypropyl-cellulose, un poly(vinyl-acétal) porteur de radicaux hydroxy, une résine obtenue par réaction d'une résine époxydique avec un excès d'un composé contenant un ou plusieurs radicaux capables de réagir avec des radicaux époxy, ou un résol phénolique.

5. Compositions selon l'une quelconque des revendications 1 a 4, dans lesquelles les symboles $R^3$ et $R^4$ représentent des radicaux phényles éventuellement substitués.

6. Compositions selon l'une quelconque des revendications 1 à 5, dans lesquelles l'anion $Z^{x-}$ dérive d'un acide carboxylique organique, d'un acide sulfonique organique $Y-SO_3H$ dans lequel Y représente un radical aliphatique, un radical aromatique ou un radical aromatique porteur de substituants aliphatiques, chacun de ces radicaux pouvant éventuellement porter un ou plusieurs atomes d'halogènes, ou d'un acide minéral.

7. Compositions selon la revendication 6 dans lesquelles l'anion $Z^{x-}$ représente un anion acetate, trifluoracétate, méthane-sulfonate, benzène-sulfonate, p-toluène-sulfonate, trifluorométhane-sulfonate, fluorure, chlorure, bromure, iodate, perchlorate, nitrate, sulfate, hydrogénosulfate, phosphate, hydrogénophosphate ou pentafluoro-hydroxo-antimoniate, ou un anion $MQ_w^-$ dans lequel M représente un atome de métal ou de métalloïde, Q représente un atome d'halogène et w représente un nombre entier de 4 à 6 qui est supérieur d'une unité à la valence de M.

8. Compositions selon la revendication 7 dans lesquelles l'anion $Z^{x-}$ représente un anion hexafluoroantimoniate, hexachloro-antimoniate, hexafluoro-arséniate, pentachloro-bismuthate, tétrachloroferrate, hexachlorostannate, tétrafluoro-borate ou hexafluoro-phosphate.

9. Compositions photopolymérisables selon l'une quelconque des revendications précédentes, compositions qui contiennent en outre un générateur de radicaux photochimique ou un photosensibilisateur.

10. Compositions thermopolymérisables selon l'une quelconque des revendications 1 à 8, compositions qui contiennent en outre (D) un sel ou un complexe d'un métal de transition de la première série de transition allant du scandium au zinc ou de la seconde série de transition allant de l'yttrium au cadmium, un sel d'étain (II), un peroxyde organique ou un composé α-hydroxylique activé capable de former des radicaux libres lorsqu'il est chauffé à une température supérieure à 50° C, comme catalyseur pour le sel d'iodosyle.

11. Compositions selon la revendication 10 dans lesquelles (D) est le peroxyde de dicumyle, le perbenzoate de tert-butyle, le peroxyde de tert-butyle, le peroxyde de benzoyle ou un sel ou complexe de zinc, de cobalt, de chrome, de fer ou de cuivre.

12. Procédé de préparation d'une matière polymère, procédé caractérisé en ce qu'il comporte les étapes suivantes:

(i) on expose une composition selon la revendication 1 à un rayonnement d'une longueur d'onde activant le sel d'iodosyle, et/ou

(ii) on chauffe à plus de 50°C la composition selon la revendication 1, ou la composition obtenue par irradiation de la composition selon la revendication 1, en présence (D) d'un sel ou d'un complexe d'un métal de transition de la premiere série de transition allant du scandium au zinc ou de la seconde série de transition allant de l'yttrium au cadmium, d'un sel d'étain (II), d'un peroxyde organique ou d'un composé α-hydroxylique activé engendrant des radicaux libres lorsqu'il est chauffé à plus de 50°C, comme catalyseur pour le sel d'iodosyle, jusqu'à ce que la composition soit polymérisée.